# FASCICULE DE BREVET EUROPEEN

(11) **EP 0 627 707 B1**
(45) Date de publication et mention de la délivrance du brevet: **15.12.1999**
(21) Numéro de dépôt: 93401397.0
(22) Date de dépôt: 02.06.1993
(51) Int. Cl.: G06K 19/077

(54) **Procédé de fabrication d'une carte à mémoire et carte à mémoire ainsi obtenue**
Verfahren zur Herstellung einer Speicherkarte und nach diesem Verfahren hergestellte Speicherkarte
Method of manufacturing a memory card and memory card obtained thereby

(43) Date de publication de la demande: 07.12.1994
(73) Titulaire: SCHLUMBERGER Systèmes, 92120 Montrouge (FR)
(72) Inventeur: Audoux, Jean-Noel, F-45570 Ouzouer sur Loire (FR); Gaumet, Michel, F-45560 Saint-Denis-en-Val (FR); Gouiller, Michel, F-45160 Olivet (FR); Thevenot, Benoît, F-45160 Olivet (FR)
(74) Mandataire: Bugnon-Hays, Claudine

(56) Documents cités:
- EP-A- 0 344 058
- EP-A- 0 426 406
- GB-A- 2 096 541
- PATENT ABSTRACTS OF JAPAN vol. 11, no. 319 (P-627)(2766) 17 Octobre 1987 & JP-A-62 107 391 ( NIPPON TEXAS INSTR. K.K. ) 18 Mai 1987

## Description

La présente invention concerne un procédé de fabrication d'une carte à mémoire et une carte à mémoire.

On connaît du document FR-A-2.671.416 un procédé pour la fabrication d'une carte à mémoire comprenant un corps en matière isolante pourvu d'un circuit intégré comportant sur sa face supérieure des plots que des conducteurs en encre conductrice relient électriquement à des contacts de lecture/écriture, procédé comprenant une étape consistant à déposer une couche de vernis diélectrique sur la face supérieure du circuit intégré, sauf sur les plots de ce dernier, une étape consistant à ménager une cavité dans le corps de la carte, et une étape consistant à réaliser des conducteurs après avoir introduit le circuit intégré dans la cavité. Voir aussi le préambule de la revendication 5.

Les cavités ménagées dans le corps des cartes à mémoire actuelles sont réalisées avec une très grande précision afin d'immobiliser parfaitement les circuits intégrés et d'éviter ainsi une interruption accidentelle des liaisons électriques entre les plots de ces derniers et les contacts de lecture/écriture.

La réalisation de ces cavités a toutefois l'inconvénient de demander beaucoup de temps et d'entraîner des coûts d'usinage relativement importants.

Les liaisons électrices établies entre les plots des circuits intégrés et les contacts de lecture/écriture ont par ailleurs tendance à se détériorer assez rapidement lorsque les cartes à mémoire sont soumises à des efforts de flexion ou de torsion lors de leur utilisation.

La présente invention se propose de remédier à ces inconvénients et, pour ce faire, elle a pour objet un procédé pour la fabrication d'une carte à mémoire comprenant un corps en matière isolante pourvu d'un circuit intégré, ayant une surface supérieure recouverte d'une couche diélectrique sauf sur des plots que des conducteurs en encre conductrice relient électriquement à des contacts de lecture/écriture, procédé comprenant une étape consistant à ménager une cavité dans le corps de la carte et les étapes d'appliquer l'une contre l'autre la couche diélectrique et une face adhésive d'un ruban adhésif dont les dimensions sont plus grandes que celles du circuit intégré, d'introduire le circuit intégré dans la cavité, ses plots étant tournés vers l'extérieur, d'appliquer la partie libre de la face adhésive du ruban adhésif sur le corps de la carte, à la périphérie de la cavité, de former les contacts de lecture/écriture et les conducteurs par dépôt d'une encre conductrice sur une autre face du ruban adhésif, lequel est apte à permettre des liaisons électriques entre les plots et les conducteurs, et de former une seconde couche diélectrique sur le ruban adhésif et sur les parties du dépôt d'encre qui ne constituent pas les contacts de lecture/écriture.

En fixant le circuit intégré à un ruban adhésif et en l'introduisant ensuite dans la cavité, on l'immobilise parfaitement sans qu'il soit nécessaire de réaliser ladite cavité avec précision, ce qui permet de simplifier les opérations d'usinage et de réduire les coûts de production. De plus, en formant les conducteurs et les contacts de lecture/écriture sur le ruban adhésif, on augmente la résistance des cartes à mémoire vis à vis des efforts de flexion ou de tension.

Selon un premier mode de mise en oeuvre, le procédé conforme à l'invention consiste à utiliser un ruban adhésif comportant des trous répartis de telle sorte qu'ils soient à l'aplomb des plots du circuit intégré et de la partie externe de la plage de conduction lorsque ledit ruban adhésif et le circuit intégré sont appliqués l'un contre l'autre, l'encre conductrice assurant les liaisons électriques en remplissant les trous.

Selon un second mode de mise en oeuvre, le procédé conforme à l'invention consiste à utiliser un ruban adhésif apte à devenir localement conducteur de l'électricité sous l'action d'une pression exercée sur lui perpendiculairement à son plan, et à exercer des pressions sur les parties du ruban adhésif se trouvant à l'aplomb des plots et de la partie extérieure de la plage de conduction, les parties pressées du ruban adhésif reliant électriquement l'encre conductrice avec les plots et la partie extérieure de la plage de conduction.

La présente invention concerne également une carte à mémoire comportant un corps en matière isolante comprenant une cavité dans laquelle est disposé un circuit intégré ayant des plots tournés vers l'extérieur et comportant une première couche diélectrique s'étendant sur la face supérieure du circuit intégré sauf les plots de celui-ci, des conducteurs en résine synthétique conductrice reliant les plots à des contacts de lecture/ écriture, et une seconde couche diélectrique s'étendant sur les conducteurs, caractérisé en ce qu'un ruban adhésif est fixé par une face adhésive à la première couche diélectrique et au corps autour de la cavité, et en ce que les conducteurs ainsi que les contacts de lecture/écriture auxquels ils sont reliés s'étendent sur une autre face du ruban adhésif.

Deux modes d'exécution du procédé conforme à l'invention seront décrits ci-après à titre d'exemples nullement limitatifs en référence aux dessins annexés dans lesquels :
- la figure 1 est une vue de dessus schématique, partielle et avec arrachement d'une carte à mémoire obtenue par la mise en oeuvre du procédé conforme à l'invention ;
- la figure 2 est une vue en coupe schématique selon la ligne II-II de la figure 1 ;
- la figure 3 est une vue en coupe partielle montrant le circuit intégré après le dépôt de la première couche de vernis diélectrique ;
- la figure 4 est une vue partielle de dessus montrant le circuit intégré et la première couche de vernis visibles sur la figure 3 ;
- la figure 5 est une vue en coupe partielle montrant le corps de la carte après la réalisation de la cavité et de la plage de conduction ;
- la figure 6 est une vue partielle de dessus montrant le corps de la carte, la cavité et la plage de conduction visibles sur la figure 5 ;
- la figure 7 est une vue en coupe montrant le circuit intégré et le ruban adhésif fixés l'un contre l'autre par l'intermédiaire de la première couche de vernis, cet ensemble étant représenté au-dessus de la cavité du corps de la carte ;
- la figure 8 est une vue partielle de dessus montrant le circuit intégré dans la cavité et le ruban adhésif appliqué contre le corps de la carte ;
- la figure 9 est une vue partielle en coupe montrant le corps de la carte après le dépôt de l'encre conductrice sur le ruban adhésif ;
- la figure 10 est une vue partielle de dessus montrant le corps de la carte visible sur la figure 9 ; et
- les figures 11 à 14 illustrent une variante de réalisation du procédé conforme à l'invention et correspondent respectivement aux figures 7 à 10.

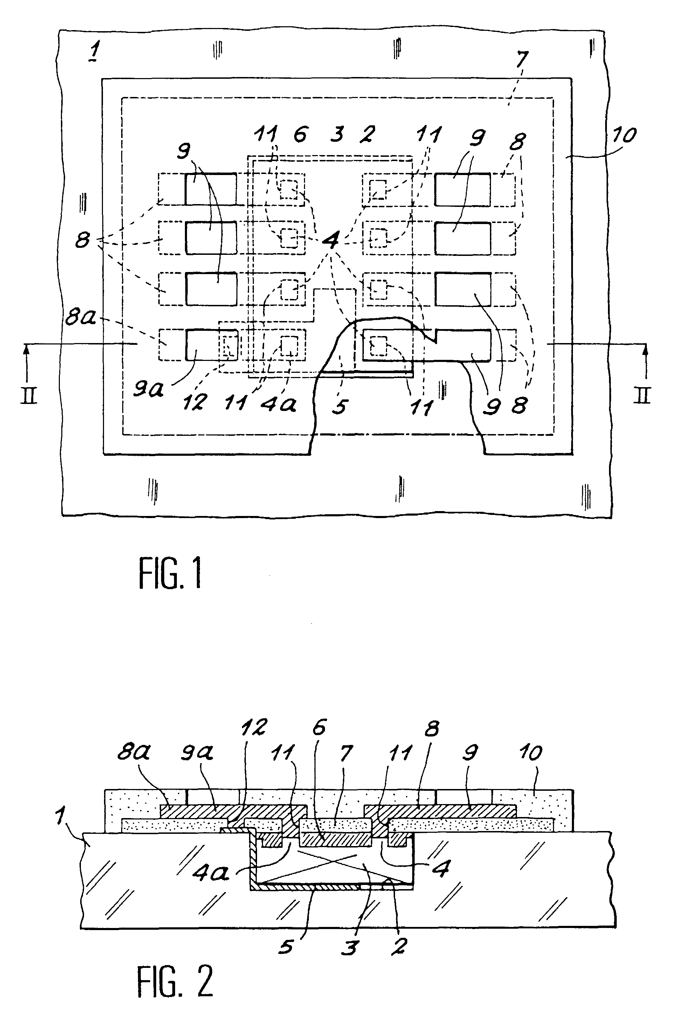

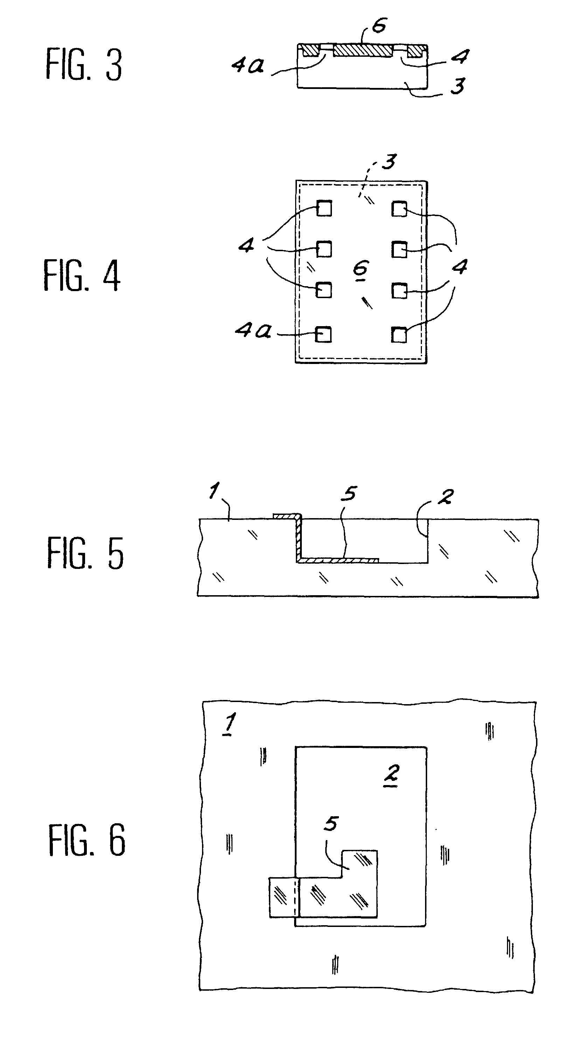

Les figures 1 et 2 sont des vues partielles, respectivement de dessus et en coupe, d'une carte à mémoire fabriquée par la mise en oeuvre du procédé conforme à l'invention.

Cette carte comporte un corps 1 réalisé en matière isolante, par exemple en matière plastique, et pourvue d'une cavité 2 dans laquelle est logé un circuit intégré 3 comportant sur sa face supérieure des plots 4 dont l'un deux constitue un plot de masse 4a.

Elle comporte également une plage de conduction 5 comprenant une partie interne dans la cavité 2 et une partie externe hors de celle-ci, une première couche de vernis diélectrique 6 recouvrant la face supérieure du circuit intégré 3 à l'exception des plots 4 et 4a de celui-ci, un ruban adhésif 7 appliqué contre la première couche de vernis 6 et contre le corps 1, autour de la cavité 2, des conducteurs 8 prévus sur le ruban adhésif 7 et reliés électriquement aux plots 4, un conducteur 8a également prévu sur le ruban adhésif et relié quant à lui au plot 4a et à la partie externe de la plage de conduction 5, des contacts de lecture/écriture 9 constitués par des zones particulières des conducteurs 8, un contact de lecture/écriture 9a constitué par une zone particulière du conducteur 8a, et une seconde couche de vernis diélectrique 10 recouvrant le ruban adhésif 7, les conducteurs 8,8a à l'exception de leurs zones constituant les contacts de lecture/écriture 9,9a, et les parties de la première couche de vernis 6 qui ne portent pas les conducteurs 8,8a.

Dans l'exemple représenté, la cavité 2 a une profondeur telle que la face supérieure de la couche de vernis 6 soit sensiblement dans le plan de la face supérieure du corps 1 de la carte. Elle a par ailleurs en plan des dimensions légèrement supérieures à celles du circuit intégré.

Par ailleurs, la plage de conduction 5 est formée par polymérisation d'une encre conductrice constituée d'une résine synthétique chargée en pigments conducteurs et apte à être déposée par sérigraphie.

Le ruban adhésif 7 comporte des trous 11 à l'aplomb des plots 4,4a du circuit intégré 3 et un trou 12 à l'aplomb de la partie externe de la plage de conduction 5, ces différents trous étant remplis par une encre conductrice déposée par sérigraphie sur le ruban adhésif 7 pour constituer les conducteurs 8 et 8a.

D'autre part, les vernis utilisés pour former les première et seconde couches 6 et 10, sont constitués de résines synthétiques déposées par sérigraphie et peuvent être identiques ou différentes, le vernis formant la première couche 6 ayant la particularité d'être compatible avec les semi-conducteurs et de pouvoir être insolé avec un faisceau laser ou un faisceau de rayons ultraviolets, visibles ou infrarouges, ou être abradé mécaniquement ou chimiquement.

On va maintenant décrire le procédé qu'il convient de mettre en oeuvre pour fabriquer la carte à mémoire visible sur les figures 1 et 2.

Tout d'abord, on dépose par sérigraphie la première couche de vernis diélectrique 6 sur la face supérieure du circuit intégré 3, sauf sur les plots 4,4a de ce dernier (voir les figures 3 et 4).

La couche 6 est de préférence déposée sous sa configuration définitive en une seule étape. Elle pourrait cependant être formée en plusieurs étapes consistant successivement à déposer sur la face supérieure du circuit intégré 3 et sur les plots 4,4a un vernis polymérisable sous l'action d'un faisceau lumineux, par exemple un faisceau laser ou un faisceau de rayons ultraviolets, visibles ou infrarouges, à recouvrir à l'aide d'un masque les parties du vernis qui sont situées à l'aplomb des plots 4,4a, à exposer au faisceau lumineux les autres parties du vernis afin de les polymériser, à enlever le masque, et à éliminer les parties non polymérisées du vernis qui recouvrent les plots 4,4a.

On réalise ensuite la cavité 2 dans le corps 1 de la carte, par exemple par fraisage, après quoi l'on dépose une encre conductrice en partie dans la cavité 2 et en partie hors de celle-ci afin de former la plage de conduction 5 (voir les figures 5 et 6).

On notera ici que la cavité 2 peut avoir en plan des dimensions légèrement supérieures à celles du circuit intégré 3. Il n'est pas nécessaire en effet qu'elle ait en plan des dimensions précises pour les raisons qui seront rappelées ci-après.

On notera également qu'on pourrait déposer l'encre constituant la plage de conduction 5 avant de réaliser la cavité 2 par déformation du corps 1, par exemple par thermoformage ou par formage par ultrasons.

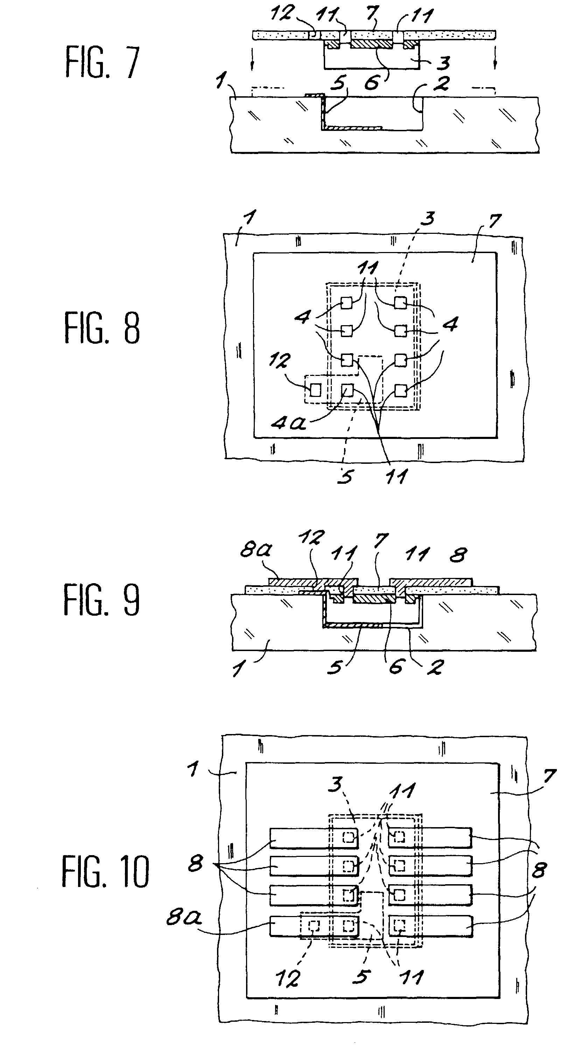

On applique ensuite la couche de vernis 6 déposée sur le circuit intégré 3 contre la face adhésive du ruban adhésif (voir la figure 7), après quoi l'on introduit le circuit intégré 3 dans la cavité 2 du corps 1 de façon à ce que ses plots soient tournés vers l'extérieur et qu'il vienne en contact avec la partie interne de la plage de conduction 5 ; après quoi l'on applique la partie libre de la face adhésive du ruban adhésif contre le pourtour de la cavité 2 (voir les figures 7 et 8).

Le ruban adhésif 7 immobilise parfaitement le circuit intégré dans la cavité, ce qui évite que celle-ci soit réalisée avec des dimensions en plan précises.

Il convient de noter que le ruban adhésif est perforé à l'avance, ses trous 11 et 12 étant répartis de façon à correspondre respectivement aux plots 4,4a du circuit intégré 3 et à la partie externe de la plage de conduction 5. Il peut avantageusement être pourvu d'une succession de séries de trous 11,12 réparties judicieusement les unes à la suite des autres et être coupé à longueur avant ou après que plusieurs circuits intégrés aient été appliqués contre lui.

On précisera par ailleurs que la face supérieure de la couche de vernis 6 est coplanaire avec la face supérieure du corps 1 lorsque le circuit intégré 3 est en place dans la cavité 2.

On dépose ensuite sur le ruban adhésif 7, par sérigraphie, une encre conductrice destinée à constituer les conducteurs 8,8a et les contacts de lecture/écriture 9,9a, cette encre remplissant les trous 11,12 du ruban adhésif et permettant ainsi de relier électriquement les plots 4,4a du circuit intégré et la partie externe de la plage de conduction 5 avec les contacts de lecture/écriture qui sont en fait des zones particulières des conducteurs 8,8a (voir les figures 9 et 10).

L'encre conductrice utilisée est déposée de préférence sous sa configuration définitive en une seule étape. Elle pourrait cependant être d'abord déposée sous la forme d'une couche ne présentant aucune discontinuité, puis enlevée sélectivement de façon à séparer les uns des autres les ensembles constitués chacun d'un conducteur et du contact de lecture/écriture associé.

On précisera à toutes fins utiles que l'enlèvement sélectif de l'encre conductrice peut être réalisé mécaniquement, par exemple à l'aide d'un stylet gratteur, thermiquement, par exemple sous l'action d'un faisceau laser, ou chimiquement.

Enfin, lorsque les conducteurs 8,8a sont réalisés, on dépose de préférence par sérigraphie la seconde couche de vernis diélectrique 10 sur les parties non recouvertes du ruban adhésif 7, sur les conducteurs 8,8a à l'exception des zones de ceux-ci qui sont destinées à constituer les contacts de lecture/écriture 9,9a, et sur la face supérieure du corps 1 de la carte, sous la forme d'une plage annulaire étroite entourant le ruban adhésif 7 (voir les figures 1 et 2).

Grâce à cette seconde couche de vernis, les conducteurs 8,8a et le ruban adhésif 7 sont parfaitement protégés contre les rayures lors de l'utilisation de la carte, ce qui permet d'utiliser cette dernière dans des conditions de fonctionnement optimales.

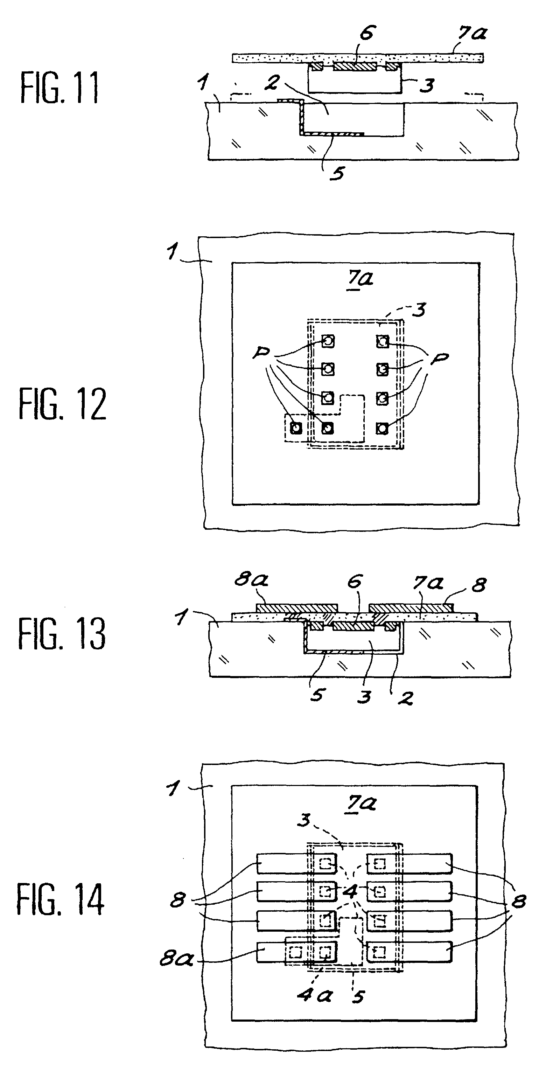

Les figures 11 à 14 illustrent les étapes particulières de la variante de mise en oeuvre du procédé qui vient d'être décrit.

Selon cette variante, le ruban adhésif perforé 7 est remplacé par un ruban adhésif non perforé 7a qui est constitué d'un matériau ayant la propriété de devenir localement conducteur sous l'action d'une pression exercée sur lui perpendiculairement à son plan.

Lorsque l'on a réalisé la cavité 2 dans le corps 1 de la carte et déposé la plage de conduction 5 en partie dans la cavité et en partie hors de celle-ci, on applique la couche de vernis 6 déposée sur le circuit intégré 3 contre la face adhésive du ruban adhésif 7a qui a été préalablement coupé à longueur (voir la figure 11).

On introduit ensuite le circuit intégré dans la cavité 2 de telle sorte que ses plots soient tournés vers l'extérieur, et l'on applique les parties libres de la face adhésive du ruban adhésif 7a contre le corps 1 de la carte, après quoi l'on exerce sur le ruban adhésif 7a, au niveau de ses parties surplombant les plots 4,4a du circuit intégré et la partie externe de la plage de conduction 5, des pressions ponctuelles destinées à le rendre localement conducteur. Sur la figure 12, on a schématisé l'application de ces forces par des cercles portant la référence P.

On réalise ensuite les conducteurs 8,8a (voir les figures 13 et 14) comme on l'a fait pour la mise en oeuvre du procédé décrit en référence aux figures 1 à 10.

Dans les deux modes de réalisation du procédé conforme à l'invention, on utilise un circuit intégré ayant huit plots. Il va de soi cependant que l'on ne sortirait pas du cadre de la présente invention si l'on utilisait un circuit intégré comportant un nombre différent de plots.

Il ressort de ce qui précède que le ruban adhésif utilisé pour fixer le circuit intégré sur le corps de la carte évite la réalisation de la cavité 2 avec des dimensions en plan précises, assure une immobilisation parfaite du circuit intégré dans ladite cavité, permet la réalisation de liaisons électriques sûres, augmente la résistance mécanique de ces dernières et rend la carte à mémoire apte à mieux résister aux efforts de flexion et de torsion exercés sur elle lors de son utilisation.

## Revendications

1. Procédé pour la fabrication d'une carte à mémoire comprenant un corps en matière isolante (1) pourvu d'un circuit intégré (3), ayant une surface supérieure recouverte d'une couche diélectrique (6) sauf sur des plots (4, 4a) que des conducteurs (8, 8a) en encre conductrice relient électriquement à des contacts de lecture/écriture (9, 9a), procédé comprenant une étape consistant à ménager une cavité (2) dans le corps (1) de la carte et les étapes d'appliquer l'une contre l'autre la couche diélectrique (6) et une face adhésive d'un ruban adhésif (7, 7a) dont les dimensions sont plus grandes que celles du circuit intégré, d'introduire le circuit intégré (3) dans la cavité (2), ses plots (4, 4a) étant tournés vers l'extérieur, d'appliquer la partie libre de la face adhésive du ruban adhésif (7, 7a) sur le corps (1) de la carte, à la périphérie de la cavité (2), de former les contacts de lecture/écriture (9, 9a) et les conducteurs (8, 8a) par dépôt d'une encre conductrice sur une autre face du ruban adhésif (7, 7a), lequel est apte à permettre des liaisons électriques entre les plots (4, 4a) et les conducteurs (8, 8a), et de former une seconde couche diélectrique (10) sur le ruban adhésif et sur les parties du dépôt d'encre qui ne constituent pas les contacts de lecture/écriture (9, 9a).

2. Procédé selon la revendication 1, caractérisé en ce que le ruban adhésif (7) utilisé comporte des trous (11, 12) répartis de telle sorte qu'ils soient à l'aplomb des plots (4, 4a) du circuit intégré (3) lorsque ledit ruban adhésif et le circuit intégré (3) sont appliqués l'un contre l'autre, l'encre conductrice assurant les liaisons électriques en remplissant les trous.

3. Procédé selon la revendication 1, caractérisé en ce que le ruban adhésif (7a) utilisé est apte à devenir localement conducteur de l'électricité sous l'action d'une pression (P) exercée sur lui perpendiculairement à son plan, et en ce qu'une pression est exercée sur les parties du ruban adhésif (7a) se trouvant à l'aplomb des plots (4, 4a), de sorte que les parties pressées du ruban adhésif (7a) relient électriquement l'encre conductrice avec les plots (4, 4a).

4. Procédé selon la revendication 2 ou la revendication 3, caractérisé en ce que préalablement à l'étape d'introduction du circuit intégré (3) dans la cavité (2) il comporte l'étape de réaliser une plage de conduction (5) comprenant une partie interne située dans la cavité et une partie externe située hors de celle-ci, et en ce que le ruban adhésif (7, 7a) est apte à permettre une liaison électrique entre la partie externe de la plage de conduction (5) et l'un (8a) des conducteurs.

5. Carte à mémoire comportant un corps en matière isolante (1) comprenant une cavité (2) dans laquelle est disposé un circuit intégré (3) ayant des plots (4, 4a) tournés vers l'extérieur et comportant une première couche diélectrique (6) s'étendant sur la face supérieure du circuit intégré sauf les plots (4, 4a) de celui-ci, des conducteurs (8, 8a) en résine synthétique conductrice reliant les plots (4, 4a) à des contacts de lecture/ écriture (9, 9a), et une seconde couche diélectrique (10) s'étendant sur les conducteurs (8, 8a), caractérisé en ce qu'un ruban adhésif (7, 7a) est fixé par une face adhésive à la première couche diélectrique (6) et au corps (1) autour de la cavité (2), et en ce que les conducteurs (8, 8a) ainsi que les contacts de lecture/écriture (9, 9a) auxquels ils sont reliés s'étendent sur une autre face du ruban adhésif (7, 7a).

6. Carte à mémoire selon la revendication 5, caractérisée en ce que le ruban (7) comporte des trous (11, 12) à l'aplomb des plots (4, 4a) du circuit intégré (3) et en ce que les conducteurs (8, 8a) s'étendent dans les trous.

7. Carte à mémoire selon la revendication 5, caractérisée en ce que le ruban (7a) comporte des parties conductrices à l'aplomb des plots (4, 4a) du circuit intégré (3) et en ce que les conducteurs (8, 8a) s'étendent sur ces parties conductrices.

8. Carte à mémoire selon la revendication 6 ou la revendication 7, caractérisée en ce qu'elle comporte une plage de conduction (5) comprenant une partie interne située dans la cavité (2) en contact avec le circuit intégré, et une partie externe située hors de la cavité, en liaison électrique avec l'un (8a) des conducteurs.

9. Carte à mémoire selon la revendication 8, caractérisée en ce que la plage conductrice (5) est en résine synthétique conductrice.

## Patentansprüche

1. Verfahren zur Herstellung einer Speicherkarte umfassend einen Körper aus einem Isoliermaterial (1), der mit einem integrierten Schaltkreis (3) versehen ist, der eine Oberfläche hat, die außer auf Kontakten (4, 4a), welche Leiter (8, 8a) aus leiffähiger Tinte elektrisch mit Lese-/Schreibkontakten (9, 9a) verbinden, mit einer dielektrischen Schicht (6) überzogen ist, wobei das Verfahren einen Schritt umfaßt, der aus dem Ausbilden eines Hohlraumes (2) in dem Körper (1) der Karte besteht, und ferner die Schritte des Aneinanderlegens der dielektrischen Schicht (6) und einer klebenden Seite eines Klebebandes (7, 7a), dessen Abmessungen größer als die des integrierten Schaltkreises sind, des Einsetzens des integrierten Schaltkreises (3) in den Hohlraum (2), wobei die Kontakte (4, 4a) des integrierten Schaltkreises nach außen gerichtet sind, des Auflegens des freien Abschnittes der klebenden Seite des Klebebandes (7, 7a) auf den Körper (1) der Karte am Umfang des Hohlraumes (2), des Ausbildens der Lese-/Schreibkontakte (9, 9a) und der Leiter (8, 8a) durch Auftragen einer leitfähigen Tinte auf einer anderen Seite des Klebebandes (7, 7a), das dazu geeignet ist, die elektrischen Verbindungen zwischen den Kontakten (4, 4a) und den Leitern (8, 8a) zu ermöglichen, und des Ausbildens einer zweiten dielektrischen Schicht (10) auf dem Klebeband und auf den Abschnitten der Schicht aus Tinte, die nicht die Lese-/Schreibkontakte (9, 9a) bilden.

2. Verfahren nach Anspruch 1, dadurch **gekennzeichnet**, daß das verwendete Klebeband (7) Löcher (11, 12) hat, die so verteilt sind, daß sie senkrecht über den Kontakten (4, 4a) des integrierten Schaltkreises (3) liegen, wenn dieses Klebeband und der integrierte Schaltkreis (3) aneinandergelegt werden, wobei die leitfähige Tinte die elektrischen Verbindungen dadurch sicherstellt, daß sie die Löcher auffüllt.

3. Verfahren nach Anspruch 1, dadurch **gekennzeichet,** daß das verwendete Klebeband (7a) dazu geeignet ist, unter der Einwirkung eines Druckes (P), der senkrecht zur Ebene des Klebebandes ausgeübt wird, lokal elektrisch leitend zu werden, und daß ein Druck auf die sich senkrecht über den Kontakten (4, 4a) befindlichen Abschnitte des Klebebandes (7a) so ausgeübt wird, daß die dem Druck ausgesetzten Abschnitte des Klebebandes (7a) die leitfähige Tinte elektrisch mit den Kontakten (4, 4a) verbinden.

4. Verfahren nach Anspruch 2 oder Anspruch 3, dadurch **gekennzeichnet**, daß es vor dem Schritt des Einsetzens des integrierten Schaltkreises (3) in den Hohlraum (2) den Schritt des Erzeugens eines leitenden Bereiches (5) umfaßt, der aus einem inneren Abschnitt, der sich in dem Hohlraum befindet, und einem äußeren Abschnitt, der sich außerhalb dieses befindet, besteht, und daß das Klebeband (7, 7a) dazu geeignet ist, eine elektrische Verbindung zwischen dem äußeren Abschnitt des leitenden Bereiches (5) und einem (8a) der Leiter zu ermöglichen.

5. Speicherkarte umfassend einen Körper (1) aus einem Isoliermaterial mit einem Hohlraum (2), in dem ein integrierter Schaltkreis (3) mit nach außen gerichteten Kontakten (4, 4a) angeordnet ist, und umfassend eine erste dielektrische Schicht (6), die sich außer auf den Kontakten (4, 4a) des integrierten Schaltkreises auf dessen Oberfläche erstreckt, wobei Leiter (8, 8a) aus leitfähigem Kunstharz die Kontakte (4, 4a) mit den Lese-/Schreibkontakten (9, 9a) verbinden, und eine zweite dielektrische Schicht (10), die sich auf den Leitern (8, 8a) erstreckt, dadurch **gekennzeichnet**, daß ein Klebeband (7, 7a) mittels einer klebenden Seite an der ersten dielektrischen Schicht (6) und um den Hohlraum (2) herum an dem Körper (8, 8a) befestigt ist, und daß die Leiter (8, 8a) sowie die Lese-/Schreibkontakte (9, 9a), mit denen sie verbunden sind, sich auf einer anderen Seite des Klebebandes (7, 7a) erstrecken.

6. Speicherkarte nach Anspruch 5, dadurch **gekennzeichnet**, daß das Band (7) senkrecht über den Kontakten (4, 4a) des integrierten Schaltkreises (3) Löcher (11, 12) hat, und daß sich die Leiter (8, 8a) in die Löcher hinein erstrecken.

7. Speicherkarte nach Anspruch 5, dadurch **gekennzeichnet**, daß das Band (7a) senkrecht über den Kontakten (4, 4a) des integrierten Schaltkreises (3) leitende Abschnitte hat, und daß sich die Leiter (8, 8a) auf diesen leitenden Abschnitten erstrecken.

8. Speicherkarte nach Anspruch 6 oder Anspruch 7, dadurch **gekennzeichnet**, daß sie einen leitenden Bereich (5) hat, der aus einem inneren Abschnitt, der sich in dem Hohlraum (2) in Kontakt mit dem integrierten Schaltkreis befindet, und aus einem äußeren Abschnitt besteht, der sich außerhalb des Hohlraumes in elektrischer Verbindung mit einem (8a) der Leiter befindet.

9. Speicherkarte nach Anspruch 8, dadurch **gekennzeichnet**, daß der leitende Bereich (5) aus leitfähigem Kunstharz ist.

## Claims

1. A process for the production of a memory card comprising a body (1) of insulating material provided with an integrated circuit (3), having a top surface covered by a dielectric layer (6) except over terminals (4, 4a) that conductors (8, 8a) of conductive ink electrically connect to read/write contacts (9, 9a), the process comprising a step which involves providing a cavity (2) in the body (1) of the card and the steps of applying to each other the dielectric layer (6) and an adhesive face of an adhesive strip (7, 7a) whose dimensions are larger than those of the integrated circuit, introducing the integrated circuit (3) into the cavity (2), its terminals (4, 4a) being directed outwardly, applying the free part of the adhesive face of the adhesive strip (7, 7a) to the body (1) of the card, at the periphery of the cavity (2), forming the read/write contacts (9, 9a) and the conductors (8, 8a) by the deposit of a conductive ink on another face of the adhesive strip (7, 7a), which is capable of permitting electrical connections between the terminals (4, 4a) and the conductors (8, 8a), and forming a second dielectric layer (10) on the adhesive strip and on the parts of the ink deposit which do not constitute the read/write contacts (9, 9a).

2. A process according to claim 1 characterised in that the adhesive strip (7) used comprises holes (11, 12) distributed in such a way that they are in line with the terminals (4, 4a) of the integrated circuit (3) when said adhesive strip and the integrated circuit (3) are applied to each other, the conductive ink providing the electrical connections by filling the holes.

3. A process according to claim 1 characterised in that the adhesive strip (7a) used is capable of locally becoming an electrical conductor under the action of a pressure (P) applied thereto perpendicularly to the plane thereof, and that a pressure is applied to the parts of the adhesive strip (7a) which are disposed in line with the terminals (4, 4a) in such a fashion that the pressed parts of the adhesive strip (7a) electrically connect the conductive ink to the terminals (4, 4a).

4. A process according to claim 2 or claim 3 characterised in that prior to the step of introducing the integrated circuit (3) into the cavity (2) it comprises the step of producing a conduction portion (5) comprising an internal part disposed in the cavity and an external part disposed outside the cavity, and that the adhesive strip (7, 7a) is capable of permitting an electrical connection between the external part of the conduction portion (5) and one (8a) of the conductors.

5. A memory card comprising a body (1) of insulating material having a cavity (2) in which there is disposed an integrated circuit (3) having terminals (4, 4a) which are directed outwardly and comprising a first dielectric layer (6) extending over the top face of the integrated circuit except the terminals (4, 4a) thereof, conductors (8, 8a) of conductive synthetic resin connecting the terminals (4. 4a) to read/write contacts (9, 9a) and a second dielectric layer (10) extending over the conductors (8, 8a), characterised in that an adhesive strip (7, 7a) is fixed by an adhesive face to the first dielectric layer (6) and to the body (1) around the cavity (2), and that the conductors (8, 8a) and the read/write contacts (9, 9a) to which they are connected extend on another face of the adhesive strip (7, 7a).

6. A memory card according to claim 1 characterised in that the strip (7) comprises holes (11. 12) in line with the terminals (4, 4a) of the integrated circuit (3) and that the conductors (8, 8a) extend in the holes.

7. A memory card according to claim 5 characterised in that the strip (7a) comprises conductive parts in line with the terminals (4. 4a) of the integrated circuit (3) and that the conductors (8. 8a) extend over said conductive parts.

8. A memory card according to claim 6 or claim 7 characterised in that it comprises a conduction portion (5) comprising an internal part disposed in the cavity (2) in contact with the integrated circuit and an external part disposed outside the cavity, electrically connected to one (8a) of the conductors.

9. A memory card according to claim 8 characterised in that the conduction portion (5) is of conductive synthetic resin.
